# EUROPÄISCHE PATENTSCHRIFT

(11) **EP 2 319 099 B1**
(45) Veröffentlichungstag und Bekanntmachung des Hinweises auf die Patenterteilung: **13.03.2019**
(21) Anmeldenummer: 09776063.1
(22) Anmeldetag: 04.08.2009
(51) Int. Cl.: H01L 25/075, H01L 25/16, H01L 33/00, H01L 33/64, H01L 33/62

(54) **OPTOELEKTRONISCHES BAUTEIL**
OPTOELECTRONIC COMPONENT
COMPOSANT OPTOÉLECTRONIQUE

(30) Priorität: 03.09.2008 DE 102008045653
(43) Veröffentlichungstag der Anmeldung: 11.05.2011
(73) Patentinhaber: OSRAM Opto Semiconductors GmbH, 93055 Regensburg (DE)
(72) Erfinder: GÜNTHER, Ewald, Karl, Michael, 93128 Regenstauf (DE); HERRMANN, Siegfried, 94362 Neukirchen (DE); ZEHNDER, Ulrich, 93191 Rettenbach (DE); BRUNNER, Herbert, 93161 Sinzing (DE)
(74) Vertreter: Epping - Hermann - Fischer
(86) Internationale Anmeldenummer: PCT/DE2009/001103
(87) Internationale Veröffentlichungsnummer: WO 2010/025694

(56) Entgegenhaltungen:
- EP-A2- 1 821 348
- EP-A2- 1 821 348
- WO-A-2005/101489
- WO-A1-03/003424
- WO-A1-03/003424
- DE-A1-102005 025 416
- DE-A1-102005 041 064
- DE-A1-102007 004 301
- DE-A1-102007 004 301
- US-A1- 2005 110 033
- US-A1- 2005 110 033
- US-A1- 2006 071 229
- US-A1- 2006 071 229
- US-A1- 2007 105 212
- US-A1- 2007 105 212
- US-A1- 2007 235 863
- US-A1- 2007 272 939
- US-A1- 2007 272 939
- US-B1- 6 365 429
- US-B1- 6 365 429

## Beschreibung

Es wird ein optoelektronisches Bauteil angegeben. Optoelektronische Bauteile, wie etwa Leucht- oder Fotodioden, haben eine breite technische Anwendung gefunden. Einige Gesichtspunkte, die der Verbreitung solcher Bauteile Vorschub leisteten, sind etwa deren hohe Effizienz und hohe Lebensdauer. Auch können optoelektronische Bauteile sehr kompakt sein und nur wenig Platz einnehmen. Zur Erzielung hoher Leuchtstärken ist es allerdings oft notwendig, mehrere optoelektronische Halbleiterchips, etwa auf einem gemeinsamen Träger oder Substrat, zu kombinieren. Hierdurch resultiert eine signifikante thermische Belastung eines Bauteils.

In der Druckschrift US 2007/0235863 A1 ist ein Modul mit einem LED-Chip-Array beschrieben.

Die Druckschrift WO 2005/101489 A2 betrifft eine Gehäuse für LED-Chips und eine Lichtquelle.

Ein LED-Chip mit einer Kontaktstruktur ist in der Druckschrift DE 10 2005 025 416 A1 angegeben.

Aus der Druckschrift DE 10 2005 041 064 A1 sind ein oberflächenmontierbares optoelektronisches Halbleiterbauteil und ein Herstellungsverfahren hierfür bekannt.

Die Druckschrift US 6 365 429 B1 offenbart in Abbildung 13 die Integration eines substratlosen monolithischen Laser-Arrays mit vier Spots auf einem siliziumbasierten Steuerchip.

Gemäß der Druckschrift EP 1 821 348 A2 ist ein Vertikal-LED-Chip in einem Gehäuse untergebracht.

Der Druckschrift US 2007/0272939 A1 ist eine LED ohne Aufwachssubstrat mit vertikaler Kontaktanordnung und einer ESD-Schutzdiode zu entnehmen, bei deren Herstellung ein Siliziumwafer mit Schutzdioden mit einem Wafer mit epitaktisch gewachsenen LED-Schichten verbunden wird.

Eine LED in Kombination mit einem Beugungsgitter ist in der Druckschrift US 2005/0110033 A1 enthalten.

Temperaturregelungen für den Betrieb von LEDs sind in der Druckschrift US 2007/0105212 A1 offenbart.

Die Druckschrift WO 03/003424 A1 offenbart ein Laser-Array zur Emission von Strahlung unterschiedlicher Wellenlängen, wobei ein Array von Laserdioden ohne Aufwachssubstrat auf einem Silizium-Wafer mit integrierter Elektronik aufgebracht wird.

Eine zu lösende Aufgabe besteht darin, ein optoelektronisches Bauteil mit guten thermischen Eigenschaften anzugeben.

Die vorliegende Erfindung ist in Anspruch 1 definiert.

Erfindungsgemäß umfasst das optoelektronische Bauteil einen Träger mit einer Montageseite. Die Montageseite ist durch eine Hauptseite des Trägers gebildet. Die Montageseite ist bevorzugt eben ausgestaltet, kann aber auch Strukturierungen aufweisen. Der Träger ist mit einem Material mit einer hohen thermischen Leitfähigkeit gestaltet, die bevorzugt mindestens 50 W/(m K), insbesondere mindestens 120 W/(m K) beträgt. Der Träger weist eine ausreichende mechanische Stabilität auf, um ein Verbiegen des Trägers und eine Beschädigung von auf oder am Träger angebrachten Komponenten zu verhindern. Erfindungsgemäß umfasst der Träger ein Funktionselement. Über das Funktionselement weist der Träger mindestens eine weitere Funktion auf, die über eine mechanische Stabilisierung von auf dem Träger befindlichen Komponenten und/oder eine gemeinsame elektrische Kontaktierung von mehreren optoelektronischen Halbleiterchips hinausgeht, das Funktionselement ist also aktiv elektrisch betreibbar oder weist eine elektrische Funktion auf. Über das mindestens eine Funktionselement können die Eigenschaften des Trägers, insbesondere in Hinsicht auf thermische und elektrische Aspekte, bezüglich den Anforderungen einer konkreten Anwendung effizient angepasst werden.

Erfindungsgemäß weist das optoelektronische Bauteil mindestens vier optoelektronische Halbleiterchips auf. Die optoelektronischen Halbleiterchips sind je als Leuchtdiode gestaltet.

Erfindungsgemäß ist der optoelektronische Halbleiterchip ein substratloser Halbleiterchip. Ein solcher Halbleiterchip und ein Verfahren zu dessen Herstellung sind in der Druckschrift DE 10 2007 004 304 A1 offenbart.

Erfindungsgemäß weisen die Halbleiterchips je eine Dicke von weniger als 10 µm auf.

Erfindungsgemäß weisen die Halbleiterchips je eine Oberseite und eine dieser gegenüberliegende Unterseite auf. Oberseite und Unterseite sind von Hauptseiten des jeweiligen Halbleiterchips gebildet.

Erfindungsgemäß weisen die optoelektronischen Halbleiterchips je elektrische Kontaktierungen auf der Oberseite und der Unterseite auf. Mit anderen Worten befinden sich die elektrischen Kontaktstellen der Halbleiterchips je auf einander gegenüberliegenden Seiten.

Erfindungsgemäß sind die optoelektronischen Halbleiterchips an der Montageseite aufgebracht. Insbesondere sind die Halbleiterchips direkt auf der Montageseite befestigt. Dies schließt nicht aus, dass sich zwischen dem jeweiligen Halbleiterchip und der Montageseite ein Verbindungsmittel wie ein Kleber oder ein Lot befindet. Zusätzlich oder alternativ kann der Halbleiterchip je direkt auf dem mindestens einen Funktionselement, das dem Träger etwa integriert ist, aufgebracht sein.

Erfindungsgemäß umfasst das optoelektronische Bauteil mindestens einen elektrischen Kontaktfilm. Bevorzugt ist der Kontaktfilm mit einem Metall gestaltet. Ebenso kann der Kontaktfilm aus einem transparenten Material, beispielsweise aus der Gruppe der transparenten leitfähigen Oxide, kurz TCOs, speziell mit Indiumzinnoxid, gestaltet sein.

Erfindungsgemäß ist der Kontaktfilm strukturiert. Das heißt, der Kontaktfilm stellt Leiterbahnen auf der Oberfläche des betreffenden Halbleiterchips dar. Der strukturierte Kontaktfilm kann aufgedampft sein. Bevorzugt ist der Kontaktfilm lithographisch strukturiert. Zum Beispiel weist der Kontaktfilm mehrere L-förmige Teilbereiche auf, die von einem weiteren Teilbereich rahmenförmig umschlossen sind, wobei die L-förmigen Teilbereiche voneinander verschiedene Schenkellängen aufzeigen.

Erfindungsgemäß ist der Kontaktfilm an der Oberseite des jeweiligen optoelektronischen Halbleiterchips aufgebracht. Der Kontaktfilm dient also zur elektrischen Kontaktierung des jeweiligen Halbleiterchips. Die Strukturierung des Kontaktfilms ist bevorzugt derart gestaltet, dass nur ein geringer Anteil der Fläche der Oberseite des jeweiligen Halbleiterchips vom Kontaktfilm bedeckt ist, insbesondere weniger als 35 %, bevorzugt weniger als 20 %.

Erfindungsgemäß weist das optoelektronische Bauteil einen Träger mit einer Montageseite und mit mindestens einem Funktionselement auf. Ferner umfasst das optoelektronische Bauteil mindestens vier optoelektronische Halbleiterchips je mit einer Oberseite und einer dieser gegenüberliegenden Unterseite, wobei eine elektrische Kontaktierung der Halbleiterchips je über die Oberseite und die Unterseite erfolgt, und wobei die Unterseite je der Montageseite des Trägers zugewandt ist. Die Halbleiterchips sind auf der Montageseite aufgebracht. Weiterhin beinhaltet das optoelektronische Bauteil mindestens einen elektrischen Kontaktfilm an der Oberseite des jeweiligen Halbleiterchips, wobei der Kontaktfilm strukturiert ist.

Ein solches optoelektronisches Bauteil ist kompakt aufgebaut und weist gute thermische Eigenschaften auf.

Gemäß zumindest einer Ausführungsform des optoelektronischen Bauteils weist der Träger eine Dicke im Bereich zwischen 30 µm und 1 mm auf, insbesondere eine Dicke im Bereich zwischen 50 µm und 100 µm. Durch eine solch geringe Dicke des Trägers ist gewährleistet, dass der Träger einen geringen thermischen Widerstand aufweist. Das heißt, im Betrieb des optoelektronischen Bauteils im Halbleiterchip entstehende Wärme kann über den Träger effizient aus dem Bauteil abgeführt werden.

Gemäß zumindest einer Ausführungsform des optoelektronischen Bauteils weist der mindestens eine Halbleiterchip an einer Hauptseite zumindest stellenweise eine metallische Galvanisierungsschicht auf. Eine Dicke der Galvanisierungsschicht, in einer Richtung senkrecht zur Hauptseite des Halbleiterchips, kann 2 µm überschreiten. Die Galvanisierungsschicht ist bevorzugt an der Unterseite des Halbleiterchips aufgebracht.

Erfindungsgemäß umfasst das optoelektronische Bauteil mindestens vier, bevorzugt mindestens acht Halbleiterchips. Über die Verwendung einer Mehrzahl von Halbleiterchips kann eine leuchtstarke Lichtquelle realisiert werden.

Erfindungsgemäß sind die Halbleiterchips auf dem Träger dicht gepackt. "Dicht gepackt" bedeutet, dass die Halbleiterchips in diesem Gebiet mindestens 90 % der Fläche der Montageseite bedecken. Eine hohe Packungsdichte der Halbleiterchips führt zu einer besonders intensiven Lichtquelle, die auch eine hohe Brillanz aufweisen kann. Dadurch, dass die Halbleiterchips substratlos sind, der Träger bevorzugt dünn ausgestaltet ist und eine hohe Wärmeleitfähigkeit aufweist, kann die im Betrieb der Halbleiterchips entstehende Wärme gut abgeführt werden. Durch den geringen thermischen Widerstand der Halbleiterchips und des Trägers ist eine dichte Packung einer Mehrzahl von Halbleiterchips ermöglicht.

Erfindungsgemäß überlappen das Funktionselement und mindestens ein Halbleiterchip in einer Richtung parallel zur Montageseite. Mit anderen Worten, werden Funktionselement und Halbleiterchip auf die Montageseite projiziert, so überschneiden sich die projizierten Flächen von Funktionselement und Halbleiterchip. Durch dieses Überlappen ist eine dichte Anordnung der Halbleiterchips und somit ein kompakter Aufbau des optoelektronischen Bauteils möglich. Durch eine solche Überlappung von Funktionselementen und Halbleiterchips kann auch der thermische Widerstand des Trägers herabgesetzt sein, falls das Material des Funktionselements eine höhere Wärmeleitfähigkeit aufweist als der Träger.

Gemäß zumindest einer Ausführungsform des optoelektronischen Bauteils ist das Funktionselement im oder am Träger integriert. Das bedeutet, dass das Funktionselement monolithisch beziehungsweise einstückig mit dem Träger aufgebaut ist. Dies kann insbesondere bedeuten, dass sich das Funktionselement ganz oder teilweise zwischen der Montageseite und einer der Montageseite gegenüberliegenden Hauptfläche des Trägers befindet. Bevorzugt befindet sich das Funktionselement überwiegend, das heißt bezüglich des vom Funktionselement eingenommenen Volumens zu mindestens 80 % zwischen der Montageseite und der der Montageseite gegenüberliegenden Hauptseite des Trägers. Das Funktionselement kann auch am Träger integriert sein. Das heißt, das Funktionselement steht in direktem physischem Kontakt zum Träger. Insbesondere ist das Funktionselement fest, das heißt irreversibel, mit dem Träger verbunden. Irreversibel bedeutet, dass das Funktionselement nicht über ein Stecken oder eine Steckverbindung und nicht ohne die Zuhilfenahme von Werkzeugen entfernt und wieder angefügt werden kann. Auch eine Löt- oder Klebeverbindung ist eine irreversible Verbindung. Es ist möglich, dass beim Entfernen des Funktionselements der Träger in seiner Funktionalität zerstört wird. Durch die Integration des Funktionselements im oder am Träger reduziert sich der Platzbedarf des Bauteils.

Auch steht das Funktionselement in direktem, thermischem Kontakt zum Träger.

Erfindungsgemäß umfasst das Funktionselement elektrische Leitungen, so dass die Halbleiterchips einzeln elektronisch ansteuerbar sind. Das heißt, jeder Halbleiterchip ist separat und unabhängig von anderen Halbleiterchips bestrombar. Hierdurch kann ein Bauteil realisiert werden, das, abhängig von den konkreten Anforderungen, gezielt Licht emittieren kann. Durch die separate Ansteuerbarkeit der Halbleiterchips können sich auch die thermischen Belastungen reduzieren, da nicht benötigte Halbleiterchips, beispielsweise in einer Beleuchtungseinrichtung, abgeschaltet oder gedimmt werden können.

Gemäß zumindest einer Ausführungsform des optoelektronischen Bauteils ist jedem Halbleiterchip ein Funktionselement, insbesondere eindeutig, zugeordnet. Das Funktionselement kann sich, mindestens zum Teil, an der Unterseite des Halbleiterchips befinden. Durch eine solche Anordnung der Funktionselemente ist ein kompakter Aufbau des Bauteils realisierbar.

Gemäß zumindest einer Ausführungsform des optoelektronischen Bauteils ist der Träger und/oder das Funktionselement mit einem Halbleitermaterial oder einer Keramik gestaltet. Gemäß zumindest einer Ausführungsform des optoelektronischen Bauteils ist das Funktionselement als aktiver Kühlkörper gestaltet. Beispielsweise ist das Funktionselement ein Peltier-Element, das monolithisch im Träger integriert sein kann. Alternativ kann das Funktionselement als Lüfter oder Kühlkreislauf, beispielsweise mit einer Kühlflüssigkeit, ausgeführt sein. Über ein solches Funktionselement ist besonders effizient Wärme vom optoelektronischen Bauteil abführbar.

Erfindungsgemäß ist das Funktionselement als Schutz vor elektrostatischer Entladung ausgestaltet. Mit anderen Worten dient das Funktionselement als ESD-Schutz. Durch einen ESD-Schutz wird das Bauteil vor Kurzschlüssen, die durch eine elektrostatische Entladung hervorgerufen werden können und zu einer Zerstörung etwa eines einzelnen Halbleiterchips führen können, geschützt. Das Funktionselement ist zum Beispiel ein Varistor, eine Varistorkeramik, ein Widerstand, eine Schottky-Diode. Das Funktionselement ist mit dem Halbleiterchip etwa elektrisch parallel verschaltet. Über Kurzschlüsse können auch sehr hohe Ströme auftreten. Dies kann zu einer signifikanten thermischen Belastung des Bauteils führen, wodurch auch andere Komponenten, neben der den Kurzschluss umfassenden, zerstört werden können. Durch einen ESD-Schutz kann dies vermieden werden.

Gemäß zumindest einer Ausführungsform des optoelektronischen Bauteils ist das Funktionselement dem Träger monolithisch integriert. Der Träger ist dann zum Beispiel mit p-dotiertem Silizium gestaltet. Das Funktionselement umfasst mindestens einen n-dotierten Bereich. Hierdurch ist durch das Funktionselement, in Verbindung mit dem Träger, mindestens ein pn-Übergang realisiert. Ebenso ist es möglich, dass der Träger n-dotiert ist. In diesem Falle weist das Funktionselement mindestens einen p-dotierten Bereich auf. Ein solches Funktionselement kann Platz sparend etwa als Diode oder Transistor ausgestaltet werden.

Erfindungsgemäß ist das Funktionselement als Regelelektronik ausgestaltet. Über die Regelelektronik kann die Bestromung einzelner Halbleiterchips separat gesteuert werden. Durch die separate Ansteuerbarkeit kann ein Halbleiterchip beispielsweise gedimmt werden. Hierdurch kann sich die elektrische Leistungsaufnahme des Bauteils verringern, wodurch die thermischen Belastungen reduziert sind.

Gemäß zumindest einer Ausführungsform des optoelektronischen Bauteils ist der Träger durch das Funktionselement gebildet. Beispielsweise ist das Funktionselement ein Chip auf Siliziumbasis, der integrierte Schaltkreise umfasst, die etwa als Regelelektronik gestaltet sind. Auf diesem Chip ist dann mindestens ein optoelektronischer Halbleiterchip beziehungsweise eine Leuchtdiode aufgebracht.

Gemäß zumindest einer Ausführungsform des optoelektronischen Bauteils umfasst das Funktionselement mindestens einen Sensor für Temperatur und/oder Strahlung. Der Sensor kann als temperaturabhängiger Widerstand oder als Fotodiode ausgestaltet sein. Ist der Sensor ein Temperatursensor, so steht dieser bevorzugt in thermischem Kontakt zu dem mindestens einen Halbleiterchip. Ist der Sensor ein Strahlungssensor, so kann die Strahlung der Leuchtdiodenchips oder eine externe, nicht vom Bauteil stammende Strahlung detektiert werden. Über solche Sensoren kann das Bauteil beispielsweise vor einer thermischen Überlastung geschützt werden.

Gemäß zumindest einer Ausführungsform des optoelektronischen Bauteils ist das Funktionselement eine Adressiereinheit. Über das Funktionselement sind die Halbleiterchips dann adressierbar und/oder zuordenbar. Zum Beispiel ist über das mindestens eine Funktionselement jedem der Halbleiterchips oder Gruppen von Halbleiterchips eine eindeutige Adresse zugeordnet, über die der Halbleiterchip oder die Gruppe gezielt ansteuerbar ist.

Gemäß zumindest einer Ausführungsform des optoelektronischen Bauteils ist die Regelelektronik über mindestens eine Signalleitung mit mindestens einem Sensor verbunden. Das Signal des Sensors wird in die Regelelektronik eingespeist. Eine Regelung eines Stromflusses durch den mindestens einen optoelektronischen Halbleiterchip erfolgt zumindest basierend auf dem Signal des Sensors. Beispielsweise kann die Regelelektronik, abhängig von der Temperatur des Bauteils, einzelne oder auch alle optoelektronischen Halbleiterchips des Bauteils abschalten. Dadurch kann vermieden werden, dass das optoelektronische Bauteil einer zu großen thermischen Belastung ausgesetzt ist. Sind die Sensoren Strahlungssensoren, so kann beispielsweise abhängig von einer externen Strahlung die Bestromung des optoelektronischen Bauteils eingestellt werden. Bei geringer externer Strahlung, wie bei einer dunklen Umgebung, kann über die Regelelektronik die Stromstärke vergrößert werden. Eine solche Regelelektronik führt zu einer bedarfsgerechten Bestromung des Bauteils und reduziert dessen thermische Belastung. Damit erhöht sich auch die Lebensdauer des Bauteils.

Gemäß zumindest einer Ausführungsform des optoelektronischen Bauteils ist der Träger oberflächenmontierbar. Das heißt, der Träger kann über Surface Mount Technologie, kurz SMT, mit einem externen, nicht zum Bauteil gehörigen Anschlussträger verbunden werden. Dies schließt ein, dass das Bauteil die im Rahmen einer SMT-Kontaktierung auftretenden Temperaturen zerstörungsfrei aushält. Der Träger kann also insbesondere an einem Anschlussträger angelötet sein. Die Lötkontakte können großflächig ausgestaltet sein. Die Lötkontakte können mit einem Metall gestaltet sein. Über eine metallische und/oder großflächige Ausführung von Lötkontakten kann ein guter thermischer Kontakt zwischen dem Bauteil und einem externen Anschlussträger gewährleistet werden. Hierdurch verbessern sich die thermischen Eigenschaften der Anordnung.

Gemäß zumindest einer Ausführungsform des optoelektronischen Bauteils ist die elektrische Leistungsaufnahme des mindestens einen Halbleiterchips, bezogen auf eine Fläche der Oberseite des Halbleiterchips, mindestens 1 W/mm². Insbesondere beträgt die elektrische Leistungsaufnahme mindestens 5 W/mm². Durch solche elektrische Leistungsdichten ist etwa eine intensiv abstrahlende Lichtquelle durch das optoelektronische Bauteil realisierbar. Durch die Verwendung substratloser Halbleiterchips und eines dünnen Trägers mit einer hohen Wärmeleitfähigkeit und/oder in Verbindung mit einem als aktive oder passive Kühleinheit gestalteten Funktionselement können die thermischen Belastungen aufgrund einer hohen elektrischen Leistungsaufnahme bewältigt werden.

Gemäß zumindest einer Ausführungsform des optoelektronischen Bauteils ist der mindestens eine Halbleiterchip am Träger und/oder am Funktionselement angelötet oder aufgeklebt. Durch Löten oder Kleben kann eine großflächige Kontaktierung des Halbleiterchips mit dem Träger und/oder dem Funktionselement erfolgen. Hierdurch ist ein guter thermischer Kontakt zwischen Halbleiterchip und Träger und/oder Funktionselement gewährleistet.

Gemäß zumindest einer Ausführungsform des optoelektronischen Bauteils weist das Funktionselement elektrische Leitungen auf, die im Wesentlichen im Inneren des Trägers verlaufen. "Im Wesentlichen" bedeutet hierbei, dass die elektrischen Leitungen bis auf Anschlussstellen, mit denen die elektrischen Leitungen zu kontaktieren sind, innerhalb des Trägers verlaufen. Durch solche elektrische Leitungen wird die Gefahr von Kurzschlüssen verringert. Das geht damit einher, dass großflächige, insbesondere metallische Kontaktflächen zur Kontaktierung der Halbleiterchips verwendet werden können. Großflächige elektrische Kontakte wiederum führen zu einem verbesserten thermischen Kontakt zwischen dem optoelektronischen Halbleiterchip und etwa dem Träger.

Einige Anwendungsbereiche, in denen hier beschriebene optoelektronische Bauteile Verwendung finden können, sind etwa die Hinterleuchtungen von Displays oder Anzeigeeinrichtungen. Weiterhin können die hier beschriebenen optoelektronischen Bauteile auch in Beleuchtungseinrichtungen zu Projektionszwecken, in Scheinwerfern, Kfz-Scheinwerfern oder Lichtstrahlern oder in Leuchtmitteln zu Zwecken der Allgemeinbeleuchtung eingesetzt werden.

Nachfolgend wird ein hier beschriebenes Bauteil unter Bezugnahme auf die Zeichnung anhand von nicht erfindungsgemäßen Abwandlungen näher erläutert. Gleiche Bezugszeichen geben dabei gleiche oder gleich wirkende Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Schnittdarstellung eines optoelektronischen Bauteils,
- Figur 2: eine schematische Draufsicht von Kontaktfilmen und Oberseiten eines optoelektronischen Bauteils,
- Figur 3: eine schematische Schnittdarstellung eines optoelektronischen Bauteils mit Peltier-Element,
- Figur 4: eine schematische Schnittdarstellung (A) und eine schematische dreidimensionale Darstellung (B) eines optoelektronischen Bauteils mit einem ESD-Schutz, und
- Figur 5: eine schematische Schnittdarstellung eines optoelektronischen Bauteils.

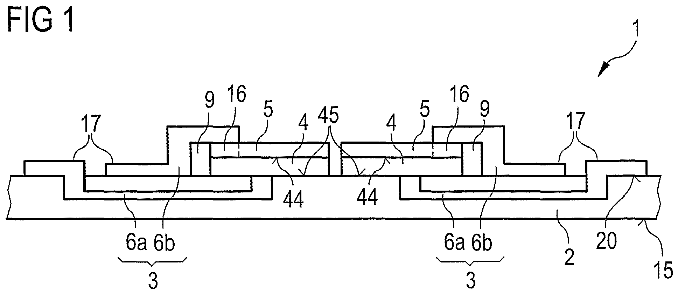

In Figur 1 ist eine Abwandlung eines optoelektronischen Bauteils 1 gezeigt. Ein Träger 2 weist eine Montageseite 20 auf, auf der optoelektronische Halbleiterchips 4 aufgelötet sind. Bei den Halbleiterchips 4 handelt es sich um substratlose Halbleiterchips. Die Halbleiterchips 4 weisen eine Oberseite 44 und eine der Oberseite 44 gegenüberliegende Unterseite 45 auf. Die Unterseite 45 ist der Montageseite 20 zugewandt. An der Oberseite 44 ist ein metallischer Kontaktfilm 5 aufgebracht. Über dem Kontaktfilm 5 ist eine gleichmäßige Stromeinspeisung in den Halbleiterchips 4 über dessen gesamte Oberfläche 44 gewährleistet. An Randbereichen der Halbleiterchips 4 befinden sich Kontaktstellen 16 zur elektrischen Kontaktierung.

Elektrische Leitungen 6a, 6b bilden ein Funktionselement 3. Über das Funktionselement 3 können die Halbleiterchips 4 einzeln elektrisch angesteuert werden. Die elektrische Leitung 6a kontaktiert die Unterseite 45. Von der Unterseite 45 ausgehend verläuft die elektrische Leitung 6a innerhalb des Trägers 2. An einem Randbereich des Trägers 2 ist die elektrische Leitung 6a zur Montageseite 20 geführt und bildet dort eine elektrische Anschlussstelle 17. Die elektrische Leitung 6b ist über die Kontaktstellen 16 elektrisch leitend mit dem Kontaktfilm 5 an der Oberseite 44 verbunden. Die elektrische Leitung 6b ist von dem Kontaktfilm 5 zur Montageseite 20 des Trägers 2 geführt. Zur Vermeidung elektrischer Kurzschlüsse sind Seitenflächen der Halbleiterchips 4 mit einem Isolator 9 versehen. Der Isolator 9 ist beispielsweise mit einem Lack gebildet. Die Dicke des Isolators 9 in einer Richtung senkrecht zur Montagefläche 20 entspricht mindestens der Höhe des Halbleiterchips 4, kann dessen Höhe aber auch um bis zu einem Faktor 5 überragen. Durch den Isolator 9 resultierende Unebenheiten können von der elektrischen Leitung 6b überbrückt werden, ohne dass die elektrische Leitung 6b unterbrochen wird. Auch das sich auf der Montageseite 20 befindliche Ende der elektrischen Leitung 6b stellt eine Anschlussstelle 17 dar.

Anders als in Figur 1 gezeigt können die elektrischen Leitungen 6a, 6b auch zu einer der Montageseite 20 gegenüberliegenden Trägerunterseite 15 führen. Die von den Enden der elektrischen Leitung 6a gebildeten elektrischen Anschlussstellen 17 können großflächig ausgeführt sein, um einen guten thermischen Kontakt über Kleben oder Löten zu einem nicht gezeichneten, nicht zum Bauteil 1 gehörigen externen Anschlussträger zu gewährleisten. Über eine solche Verbindung und über eine dünne Ausgestaltung des Trägers 2 ist eine gute thermische Kopplung zwischen den Halbleiterchips 4 und dem nicht gezeichneten externen Anschlussträger realisiert.

Ebenso ist es, anders als in Figur 1 gezeigt, möglich, dass sich alle Anschlussstellen 17 in einem kleinen Gebiet auf dem Träger 2 konzentrieren. Insbesondere können alle Anschlussstellen 17 in einer Reihe oder in einer Doppelreihe entlang einer Kante des Trägers 2 angeordnet sein.

Die Halbleiterchips 4 befinden sich in einer Richtung parallel zur Montageseite 20 nahe beieinander. Da es sich in Figur 1 um eine Schnittdarstellung handelt, sind nur zwei Halbleiterchips 4 sichtbar. Es können auch zwei Reihen von Halbleiterchips 4 auf der Montageseite 20 angebracht sein. Ebenso möglich ist es, das mehrere Reihen, insbesondere Doppelreihen, lateral versetzt auf dem Träger 2 angebracht sind.

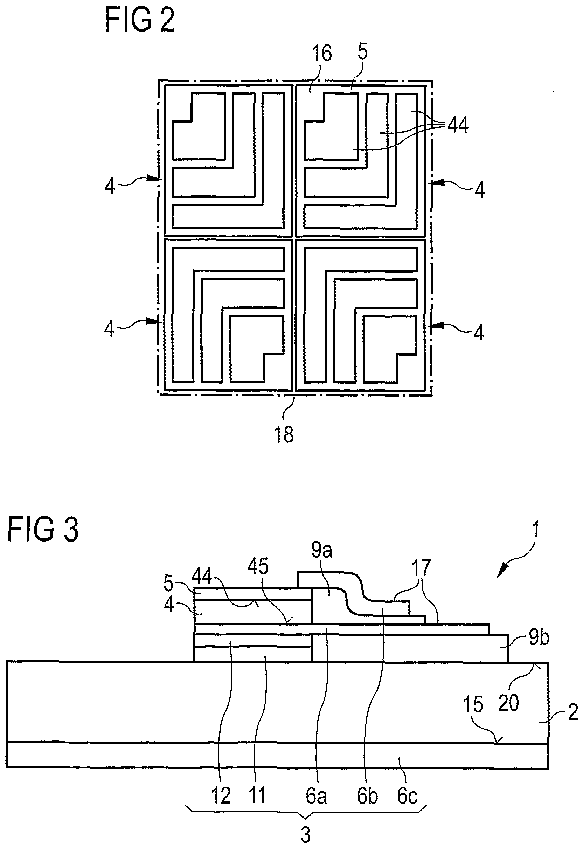

In Figur 2 ist eine Draufsicht auf die Oberseiten 44 der Halbleiterchips 4 gezeigt. Auf jeder Oberseite 44 ist ein Kontaktfilm 5 aufgebracht. Die Kontaktfilme 5 bedecken nur einen geringen Anteil der Fläche der Oberseiten 44. Der Kontaktfilm 5 ist streifenartig strukturiert. Die Strukturierung bildet rechteckige beziehungsweise L-förmige Felder auf der Oberfläche 44 aus. Hierdurch wird eine gleichmäßige Stromeinspeisung in die Halbleiterchips 4 erreicht.

In einer Ecke der Oberseiten 44 befindet sich jeweils eine der Kontaktstellen 16. Über die Kontaktstelle 16 werden die Kontaktfilme 5 elektrisch mit den elektrischen Leitungen 6b verbunden. Die Verbindung kann über Löten erfolgen. Die streifenartigen Teile des Kontaktfilms 5, die sich nahe der Kontaktstelle 16 befinden, können eine größere Breite aufweisen als streifenartige Bereiche des Kontaktfilms 5, die sich weiter von der Kontaktstelle 16 entfernt befinden. Dies führt zu einer gleichmäßigeren Stromeinprägung in den Halbleiterchip 4.

Gemäß Figur 2 sind vier Halbleiterchips 4 dicht gepackt angeordnet. Der Abstand zwischen benachbarten Halbleiterchips 4 ist kleiner als die laterale Ausdehnung der Halbleiterchips 4. Der Flächenanteil innerhalb eines Gebiets 18, der von den Chipoberseiten 44 bezüglich der Montageseite 20, auf den die Halbleiterchips 4 aufgebracht sind, bedeckt ist, beträgt zirka 95 %. Das Gebiet 18 umfasst die Halbleiterchips 4 und ist in Figur 2 durch eine Strichlinie umrandet. Diese kompakte Anordnung von Halbleiterchips 4 ist dadurch ermöglicht, dass es sich bei den Halbleiterchips 4 um substratlose Chips handelt, die direkt auf dem Träger 2 aufgebracht sind und somit eine gute Ableitung der im Betrieb der Halbleiterchips 4 entstehenden Wärme ermöglicht ist.

Bei der Abwandlung gemäß Figur 3 ist das Funktionselement 3 als Peltier-Element ausgeführt. Zwischen der Unterseite 45 des Halbleiterchips 4 und der Montageseite 20 des Trägers 2 ist ein Metallfilm 12 und eine Schicht 11 aus einem hoch dotierten Halbleitermaterial angebracht. Der mit Silizium gestaltete Träger 2 ist p-dotiert, die Schicht 11 hoch p-dotiert. Zur elektrischen Kontaktierung des Halbleiterchips 4 dienen elektrische Leitungen 6a, 6b. Die elektrische Leitung 6b ist entsprechend gemäß Figur 1 gestaltet. Die elektrische Leitung 6a ist lateral in Randbereiche des Trägers 2 geführt und bildet eine der Anschlussstellen 17 aus.

Zur Vermeidung elektrischer Kurzschlüsse sind die elektrischen Leitungen 6a, 6b voneinander und in Richtung zum Träger 2 durch Isolatoren 9a, 9b isoliert. Die Isolatoren 9a, 9b können als Lacke ausgeführt sein.

Weiterhin ist an der Trägerunterseite 15 großflächig eine elektrische Leitung 6c aufgebracht.

Im Betrieb des Bauteils 1 ist die elektrische Leitung 6b als Anode geschaltet. Die elektrischen Leitungen 6a, 6c dienen als Kathode. Somit fließt im Betrieb Strom einerseits über die elektrische Leitung 6a durch den Halbleiterchip 4 und über die elektrische Leitung 6b. Andererseits fließt Strom über die Leitung 6a durch den Metallfilm 12, die hoch p-dotierte Schicht 11 und den Träger 2 zur elektrischen Leitung 6c. Das heißt, an der Grenzfläche zwischen dem Metallfilm 12 und der hoch p-dotierten Halbleiterschicht 11 erfolgt aufgrund des Peltier-Effekts eine Kühlung, an der Grenzfläche zwischen dem Träger 2 und elektrischen Leitung 6c eine Erwärmung. Es wird also der Halbleiterchip 4 gekühlt und die Trägerunterseite 15 erwärmt. Da die elektrische Leitung 6c großflächig ausgeprägt ist, erfolgt eine lokale Kühlung am Halbleiterchip 4 und eine großflächige, und damit geringere Erwärmung an der Trägerunterseite 15. Über die Trägerunterseite 15 und die großflächige elektrische Leitung 6c ist es optional ermöglicht, dass über einen nicht gezeichneten externen Anschlussträger die Wärme aufgrund des Peltier-Effekts und aufgrund des Betriebs des Halbleiterchips 4 vom Bauteil 1 abgeführt wird.

Die Stärke des Peltier-Effekts und damit die Kühlung des Halbleiterchips 4 kann über die Spannung zwischen elektrischer Leitung 6a und elektrischer Leitung 6c eingestellt werden.

Anders als in Figur 3 gezeichnet ist es nicht nötig, dass sich der Metallfilm 12 und insbesondere die hoch p-dotierte Schicht 11 über die gesamte Unterseite 45 des Halbleiterchips erstrecken. Auch ein punktuelles, und damit stärkeres Kühlen über strukturierte Schicht 11 ist möglich. Der Metallfilm 12 ist beispielsweise als Goldfilm ausgestaltet. Der Metallfilm 12 kann also als Reflektor für beispielsweise im Halbleiterchip 4 erzeugte Strahlung dienen.

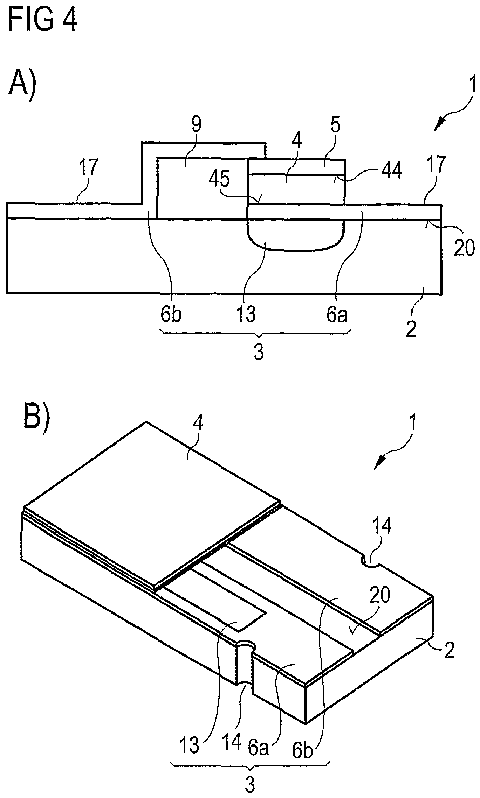

In Figur 4 ist eine Abwandlung dargestellt, bei der das Funktionselement 3 als ESD-Schutz ausgeführt ist. Als Träger 2 dient p-dotiertes Silizium. Der Träger 2 weist einen n-dotierten Bereich 13 auf. Dieser befindet sich an der Montageseite 20 dort, wo der Halbleiterchip 4 auf dem Träger 2 aufgebracht ist. Die elektrische Leitung 6b dient im Betrieb des Bauteils 1 als Kathode, die elektrische Leitung 6a als Anode. Der Halbleiterchip 4 ist entsprechend montiert. Das heißt, die p-Seite des Halbleiterchips 4 ist der Montageseite 20 zugewandt. Baut sich also außerhalb des Betriebs des Halbleiterbauteils 1 eine zur Betriebsspannung gegenpolige elektrostatische Spannung auf, so kann diese über den Träger 2 und den n-dotierten Bereich 13 sowie den elektrischen Leitungen 6a, 6b abfließen. Hierdurch wird eine Zerstörung des Bauteils verhindert.

In Figur 4B ist das optoelektronische Bauteil 1 gemäß Figur 4A schematisch dreidimensional dargestellt. Der Träger 2 kann Justagevorrichtungen 14 in Form von Ausnehmungen aufweisen, die eine passgenaue Montage auf einem externen, nicht zum Bauteil 1 gehörigen und nicht gezeichneten Anschlussträger erleichtern.

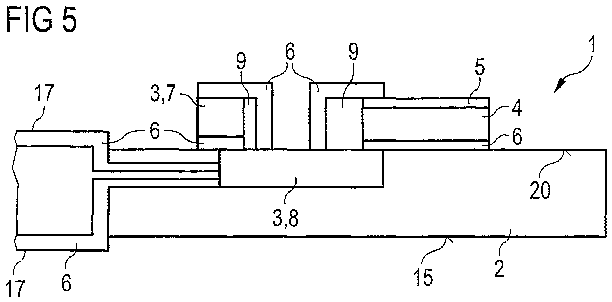

Bei der Abwandlung gemäß Figur 5 umfasst das Funktionselement 3 eine Regelelektronik 8. Die Regelelektronik 8 ist über elektrische Leitungen 6 mit einem Temperatursensor 7 und mit dem Halbleiterchip 4 verbunden. Über die Regelelektronik 8 kann, abhängig von einem Signal des Temperatursensors 7, der Halbleiterchip 4 bestromt werden. Durch eine geeignete Regelung ist somit einer thermischen Überlastung des optoelektronischen Bauteils 1 vorgebeugt.

Anders als in Figur 5 gezeigt kann auch eine Mehrzahl von Halbleiterchips 4 auf dem Träger 2 aufgebracht sein. Die verschiedenen Halbleiterchips 4 können über eine einzige Regelelektronik 8 und einen einzigen Temperatursensor 7 oder auch über eine Mehrzahl von Temperatursensoren 7 beziehungsweise Regelelektroniken 8 angesteuert werden. Zur Stromversorgung der Regelelektronik 8 sind elektrische Leitungen 6 im Träger 2 vorhanden, die an lateralen Randbereichen des Trägers 2 zur Montageseite 20 und zur Trägerunterseite 15 geführt sind. Die Endbereiche dieser Leitungen 6 können als Anschlussstellen 17 ausgestaltet sein. Eine Kontaktierung zu einem externen, nicht gezeichneten Anschlussträger ist beispielsweise über Löten, Kleben und/oder über Bonddrähte möglich.

Eine Regelelektronik gemäß Figur 5 kann auch mit einem Peltier-Element, beispielsweise wie in Figur 3 dargestellt, kombiniert sein. Die Regelelektronik 8 kann insbesondere dann die Spannung zwischen der elektrischen Leitung 6a und der elektrischen Leitung 6c regeln und somit die Kühlleistung des Peltier-Elements gezielt beeinflussen. In der Regelelektronik 8 kann ebenso ein ESD-Schutz integriert sein.

Die Regelelektronik 8 ist beispielsweise über fotolithographische Prozessschritte monolithisch im Träger 2 integriert. Beim Träger 2 kann es sich also um einen Silizium-Chip mit integrierten Schaltkreisen handeln. Der Temperatursensor 7 und/oder der Halbleiterchip 4 können an der Montageseite 20 aufgeklebt oder aufgelötet sein. Ebenso möglich ist es, dass der Temperatursensor 7 auch monolithisch im Träger 2 integriert ist, etwa in Form eines temperaturabhängigen Widerstandes.

Regelelektronik 8 und Halbleiterchip 4 überlappen lateral in eine Richtung parallel zur Montageseite 20. Hierdurch wird eine kompakte, besonders Platz sparende Anordnung realisiert. Über die Kombination einer Regelelektronik 8 mit einem Temperatursensor 7 kann eine thermische Überlastung des optoelektronischen Bauelements 1 verhindert werden.

Alternativ oder zusätzlich kann das Bauteil 1 auch einen Sensor für Strahlung beinhalten. Über diesen Sensor kann eine Strahlung vom Halbleiterchip 4 oder auch eine Strahlung der Umgebung detektiert werden. Über einen solchen Sensor kann die Bestromung, in Kombination mit einer Regelelektronik 8, den jeweiligen Anforderungen angepasst werden und somit eine thermische Belastung des Bauteils 1 reduziert werden.

Die hier beschriebene Erfindung ist nicht durch die Beschreibung anhand der Abwandlungen beschränkt.

## Patentansprüche

1. Optoelektronisches Bauteil (1) mit
- einem Träger (2) mit einer Montageseite (20) und mit mindestens einem Funktionselement (3),
- mindestens vier substratlosen, optoelektronischen Halbleiterchips (4), die als Leuchtdioden gestaltet sind, je mit einer Oberseite (44) und einer dieser gegenüberliegenden Unterseite (45) und einer elektrischen Kontaktierung über die Oberseite (44) und die Unterseite (45), wobei die Unterseiten (45) je der Montageseite (20) zugewandt und die Halbleiterchips (4) an der Montageseite (20) angebracht sind, und
- mindestens einem elektrischen Kontaktfilm (5) je an den Oberseiten (44), wobei der Kontaktfilm (5) jeweils strukturiert ist, wobei das Funktionselement (3) elektrische Leitungen (6) umfasst, sodass die Halbleiterchips (4) einzeln ansteuerbar sind,
das Funktionselement (3) eine Regelelektronik (8) und einen Schutz vor elektrostatischer Entladung umfasst und die Halbleiterchips eine Dicke von weniger als 10 µm aufweisen, und
die Halbleiterchips (4) auf dem Träger (2) dicht gepackt angebracht sind, sodass die Halbleiterchips (4) mehr als 90 % der Fläche der Montageseite (20) bedecken und die Regelelektronik (8) und mindestens ein Halbleiterchip (4) in einer Richtung parallel zur Montageseite (20) überlappen.

2. Optoelektronisches Bauteil (1) nach dem vorhergehenden Anspruch,
bei dem das Funktionselement (3) dem Träger (2), der mit p-dotiertem Silizium gestalteten ist, monolithisch integriert ist und mindestens einen n-dotierten Bereich umfasst.

3. Optoelektronisches Bauteil (1) nach einem der vorhergehenden Ansprüche,
bei dem das Funktionselement (3) Peltier-Element umfasst.

4. Optoelektronisches Bauteil (1) nach einem der vorhergehenden Ansprüche,
bei dem das Funktionselement (3) mindestens einen Sensor (7) für Temperatur und/oder Strahlung umfasst.

5. Optoelektronisches Bauteil (1) nach dem vorhergehenden Anspruch,
bei dem die Regelelektronik (8) mit dem mindestens einen Sensor (7) über eine Signalleitung verbunden ist.

6. Optoelektronisches Bauteil (1) nach einem der vorhergehenden Ansprüche,
bei die Halbleiterchips (4) auf dem Träger (2) aufgelötet oder aufgeklebt sind.

7. Optoelektronisches Bauteil (1) nach einem der vorhergehenden Ansprüche,
bei dem der Kontaktfilm (5) jeweils metallisch gestaltet ist und höchstens 35 % der Fläche der Oberseite (44) bedeckt.

## Claims

1. An optoelectronic component (1) comprising:
- a carrier (2) having a mounting side (20) and having at least one functional element (3),
- at least four substrateless optoelectronic semiconductor chips (4) which are configured as light-emitting diodes, each having an upper side (44) and a lower side (45) lying opposite said upper side (44), and an electrical conneting via the upper side (44) and the lower side (45), wherein the lower sides (45) faces the mounting side (20) and the semiconductor chips (4) are mounted on the mounting side (20), and
- at least one electrical contact film (5) in each case on the upper sides (44), wherein the contact film (5) is structured in each case,
wherein
the functional element (3) comprises electrical lines (6) so that the semiconductor chips (4) can be controlled individually,
the functional element (3) comprises control electronics (8) and a protection against electrostatic discharge, and the semiconductor chips have a thickness of less than 10 µm, and the semiconductor chips (4) are mounted in a densely packed manner on the carrier (2) so that the semiconductor chips (4) cover more than 90% of the surface of the mounting side (20), and the control electronics (8) and at least one semiconductor chip (4) overlap in a direction parallel to the mounting side (20).

2. The optoelectronic component (1) according to the preceding claim,
in which the functional element (3) is monolithically integrated in the carrier (2), which comprises p-doped silicon, and comprises at least one n-doped region.

3. The optoelectronic component (1) according to one of the preceding claims,
in which the functional element comprises a Peltier element.

4. The optoelectronic component (1) according to one of the preceding claims,
in which the functional element (3) comprises at least one sensor (7) for temperature and/or radiation.

5. The optoelectronic component (1) according to the preceding claim,
in which the control electronics (8) are connected to the at least one sensor (7) via a signal line.

6. The optoelectronic component (1) according to one of the preceding claims,
in which the semiconductor chips (4) are soldered or adhesively bonded to the carrier (2).

7. The optoelectronic component (1) according to one of the preceding claims,
in which the contact film (5) is in each case made metallic and covers at most 35% of the area of the top side (44).

## Revendications

1. Composant optoélectronique (1) comportant
- un support (2) comportant une face de montage (20) et au moins un élément fonctionnel (3),
- au moins quatre puces semi-conductrices optoélectroniques (4) sans substrat conçues sous forme de diodes électroluminescentes, ayant une face supérieure (44) et une face inférieure (45) opposée à cette première ainsi qu'un contact électrique via la face supérieure et la face inférieure, les faces inférieures (45) étant orientées chacune vers la face de montage (20), les puces semi-conductrices (4) étant agencées sur la face de montage (20), et
- au moins un film de contact électrique (5) prévu chacun sur les faces supérieures (44), le film de contact (5) étant respectivement structuré,
dans lequel
l'élément fonctionnel (3) comprend des conduites électriques (6) afin de permettre l'amorçage individuel des puces semi-conductrices(4),
l'élément fonctionnel (3) comprend une électronique de commande (8) et une protection contre les décharges électrostatiques et les puces semi-conductrices présentent une épaisseur de moins de 10 µm,
les puces semi-conductrices (2) sont densément tassées de manière que les puces semi-conductrices (4) couvrent plus de 90 % de la surface de la face de montage (20) et l'électronique de commande (8) et au moins une puce semiconductrice (4) se chevauchent dans une direction parallèle à la face de montage (20).

2. Composant optoélectronique (1) selon la revendication précédente,
dans lequel l'élément fonctionnel (3) est intégré de façon monolithique au support (2) réalisé avec du silicium dopé p et comprend au moins une zone dopée n.

3. Composant optoélectronique (1) selon l'une des revendications précédentes,
dans lequel l'élément fonctionnel (3) comprend un élément à effet Peltier.

4. Composant optoélectronique (1) selon l'une des revendications précédentes,
dans lequel l'élément fonctionnel (3) comprend au moins un capteur (7) de température et / ou de rayonnement.

5. Composant optoélectronique (1) selon la revendication précédente,
dans lequel l'électronique de commande (8) est connectée à l'au moins un capteur (7) via une ligne de signal.

6. Composant optoélectronique (1) selon l'une des revendications précédentes,
dans lequel les puces semi-conductrices (4) sont soudées ou collées sur le support (2).

7. Composant optoélectronique (1) selon l'une des revendications précédentes,
dans lequel le film de contact (5) est respectivement conçu sous forme métallique et couvre 35 % au maximum de la surface de la face supérieure (44).
